# EUROPÄISCHE PATENTSCHRIFT

(11) **EP 0 670 033 B1**
(45) Veröffentlichungstag und Bekanntmachung des Hinweises auf die Patenterteilung: **15.01.1997**
(21) Anmeldenummer: 93924428.1
(22) Anmeldetag: 17.11.1993
(51) Int. Cl.: G01D 5/25, G01R 1/20

(54) **SCHALTUNGSANORDNUNG ZUR AUFBEREITUNG VON ANALOGEN STROM- UND SPANNUNGSSIGNALEN**
CIRCUITRY FOR PROCESSING ANALOGICAL CURRENT AND VOLTAGE SIGNALS
CIRCUIT POUR LE TRAITEMENT DE SIGNAUX ANALOGIQUES DE COURANT ET DE TENSION

(30) Priorität: 17.11.1992 AT 2272/92
(43) Veröffentlichungstag der Anmeldung: 06.09.1995
(73) Patentinhaber: ELIN ENERGIEVERSORGUNG GESELLSCHAFT m.b.H., 1141 Wien (AT)
(72) Erfinder: WENDL, Kurt, A-1141 Wien (AT)
(74) Vertreter: Krause, Peter
(86) Internationale Anmeldenummer: AT9300175
(87) Internationale Veröffentlichungsnummer: WO9411707

(56) Entgegenhaltungen:
- EP-A- 0 214 780
- EP-A- 0 283 889
- UND- ODER- NOR + STEUERUNGSTECHNIK, Bd.25, Nr.3, März 1992, MAINZ DE Seiten 67 - 68 HUBER 'Für VMEbus-basierende Gehäuse: Schalter statt Steckbrücke'

## Beschreibung

Die Erfindung betrifft eine Schaltungsanordnung zur Aufbereitung von analogen Strom- und Spannungssignalen für die Weiterverarbeitung in Mikrocomputern.

Bei modernen innovativen technischen Entwicklungen ist die Tendenz zu Systemlösungen eine allgemein übliche Erscheinung, so ist es heute gebräuchlich in Kraftwerken einen Systemschutz vorzusehen. Dieser vereint ein ganzes System von Einzelschutzfunktionen in einem einzigen Hard-bzw. Softwarekonzept. Eine höhere Integrationsdichte bezüglich Hardware, Software und funktionellen Verknüpfungen ist im Prinzip vielfach die einzige Möglichkeit wesentliche Verbesserungen zu erzielen.

In der EP-A 0 283 889 ist ein Verarbeitungsmodul zur Erfassung analoger Eingangsgrößen, insbesondere für Mikroprozessorsysteme, beschrieben. Ein zugehöriger Programmspeicher wird vor dem Meßereignis programmiert, wodurch für jede Messung Halbleiterschalter entsprechend aktiviert werden. Bei diesem Verarbeitungsmodul kann jeder Eingang flexibel beschaltet werden und dient zur Aufnahme von Spannungsmeßwertgrößen, Strommeßwertgrößen oder zur Anpassung an Sensoren, wobei die Eingangskonfiguration nur durch Programmierung erfolgt. Ein Nachteil dieses Verarbeitungsmoduls ist, daß die an den Eingängen anstehenden Meßwerte nicht gleichzeitig erfaßt werden können, da die Abtastung der Eingänge seriell erfolgt. Zur Aufnahme von Meßwerten in Systemen, bei denen sich Abläufe rasch ändern, ist diese Schaltung daher nicht geeignet.

Die Aufgabe der Erfindung besteht nun darin, eine Schaltungsanordnung zu schaffen, bei der die Anzahl der Ein- und Ausgänge für die Strom- und Spannungssignale variiert werden kann und dadurch eine Anpassung an die verschiedenen Anwendungsfälle einfach möglich ist.

Die obige Aufgabe wird durch die Erfindung gelöst, welche dadurch gekennzeichnet ist, daß mindestens zwei Eingangsmodule für die Aufbereitung von Spannungssignalen und mindestens zwei Eingangsmodule für die Aufbereitung von Stromsignalen vorgesehen sind, von denen mindestens je ein Eingangsmodul über zwei Konstantstromquellen mit zwei Mikrocomputern verbunden ist, und daß am Ausgang der anderen Eingangsmodule je zwei lösbare Verbindungen angeordnet sind, die Leiterplattenstecker, einpolige Leiterplattenschalter z.B. Dual-in-line Schalter oder einpolige elektronische Schalter sind, über die entweder mindestens ein Eingangsmodul unter Zwischenschaltung von zwei Konstantstromquellen an beide Mikrocomputer anschließbar ist, oder mindestens je ein Eingangsmodul für die Spannungssignale mit dem einen Mikrocomputer und mindestens ein Eingangsmodul für die Stromsignale mit dem anderen Mikrocomputer über je eine Konstantstromquelle verbindbar ist, und daß die Anzahl der Eingänge bei beiden Mikrocomputern gleich ist, jedoch immer kleiner als die Anzahl aller Eingangsmodule, und daß die Anzahl der Konstantstromquellen der Summe der Eingänge bei beiden Mikrocomputern entspricht, und daß die Eingangsmodule, die lösbaren Verbindungen und die Konstantstromquellen auf einer Leiterplatte angeordnet sind. Die erfindungsgemäße Schaltung ist teilvariabel, d.h. bestimmte Eingangsmodule sind ausschließlich für Stromsignale oder für Spannungssignale vorgesehen. Die anderen Eingangsmodule können wahlweise über die lösbaren Verbindungen an die Mikrocomputer gelegt werden. Da die nicht variierbaren Eingangsmodule mit beiden Mikrocomputern verbunden sind werden auch die Redundanzanforderungen erfüllt. Es ist aber auch möglich mit den variablen Eingangsmodulen eine Redundanz zu erreichen. Durch die Konstantstromquellen werden Störeinflüsse und Übergangswiderstände eliminiert und es wird auch eine Langzeitkonstanz der Kalibrierung erreicht. Durch die Anordnung aller für die Schaltungsanordnung notwendigen Bauteile auf einer Leiterplatte ist die geforderte Kompaktheit gewährleistet. Da bei einem Defekt einzelner Eingangsmodule sofort die gesamte Leiterplatte ausgewechselt wird, ist auch eine große Servicefreundlichkeit der Schaltung gegeben.

Nach einer Ausgestaltung der Erfindung bestehen die Eingangsmodule für die Spannungssignale aus einem Spannungswandler, einer diesem nachgeschalteten Anpassungsschaltung der ein Tiefpaßfilter folgt und die Eingangsmodule für die Stromsignale sind aus einem Stromwandler, an den eine Strom-Spannungswandlerschaltung mit Anpassung mit nachfolgendem Tiefpaßfilter angeschlossen ist, aufgebaut. Dies ist der einfachste und kostengünstigste Aufbau der Eingangsmodule.

Von Vorteil ist weiters, daß an Stelle von jeweils vier lösbaren Verbindungen, wobei zwei von einem Eingangsmodul für die Spannungssignale und zwei von einem Eingangsmodul für die Stromsignale sind, ein zweipoliger vierstufiger Schalter vorgesehen ist, bei dem jeder Wurzelanschluß mit einer Konstantstromquelle verbunden ist, von denen jede mit einem Mikrocomputer verbunden ist, und daß in der ersten Schalterstellung der Eingangsmodul für die Spannungssignale mit beiden Mikrocomputern, in der zweiten Schalterstellung der Eingangsmodul für die Stromsignale mit beiden Mikrocomputern, in der dritten Schalterstellung der eine Eingangsmodul mit dem einen Mikrocomputer und der andere Eingangsmodul mit dem anderen Mikrocomputer und in der vierten Schalterstellung Eingangsmodule und Mikrocomputer in umgekehrter Reihenfolge miteinander verbunden ist bzw. sind. Mit dem Schalter erfolgt die Zuordnung der Eingangsmodule an die Mikrocomputer sehr einfach, da die vier Möglichkeiten bereits beim Schalter verdrahtet sind.

Eine weitere Ausgestaltung der Erfindung liegt darin, daß die beiden Mikrocomputer über je ein Flachbandkabel mit mehrpoligen Steckern mit den Konstantstromquellen verbunden sind. Dies ist die übersichtlichste und einfachste Art zwei Schaltungen auf getrennten Printplatten mit mehreren Ein- und Ausgängen miteinander zu verbinden.

Durch die Abstimmung der fixen und variablen Eingangsmodule auf die jeweilige Anforderung wird bei minimalem Hardwareeinsatz größtmögliche Freiheit beim Projektieren erreicht.

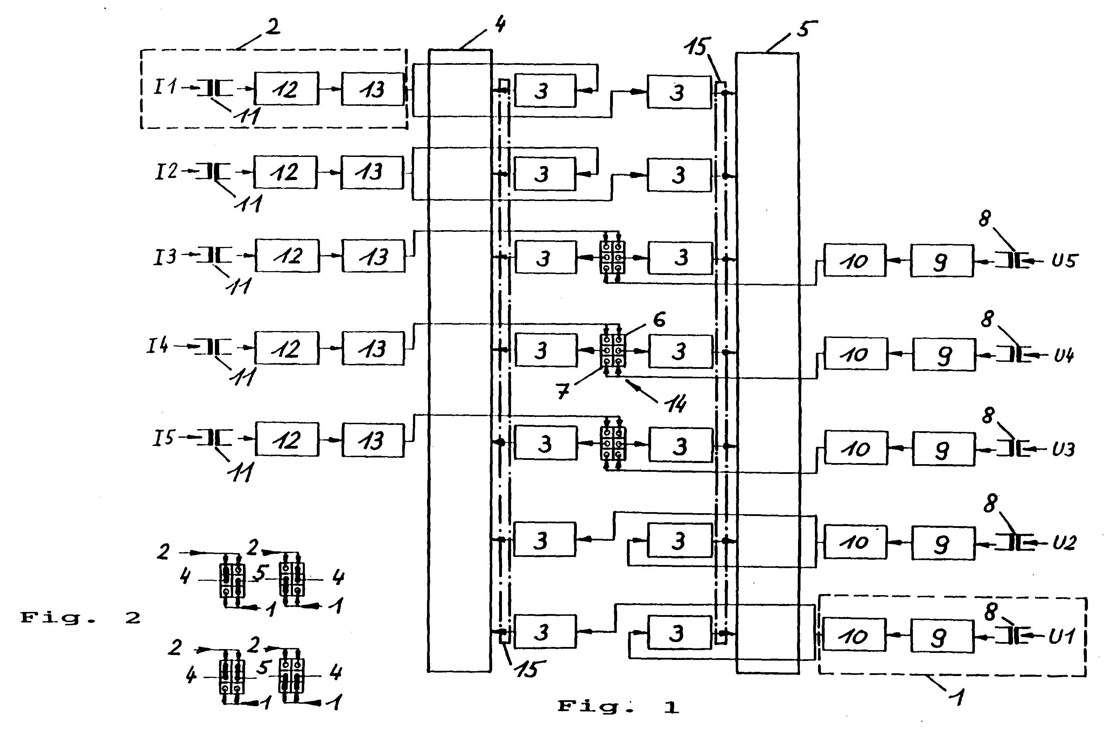

An Hand der Zeichnungen wird die Erfindung nun noch näher erläutert. Das Blockschaltbild in Fig. 1 zeigt die erfindungsgemäße Schaltungsanordnung mit zehn Eingangsmodulen und in Fig. 2 sind die möglichen Verbindungen der Leiterplattenstecker dargestellt.

In Fig. 1 sind fünf Eingangsmodule 1 für die Aufbereitung von Spannungssignalen und fünf Eingangsmodule 2 für die Aufbereitung von Stromsignalen dargestellt. Die Eingangsmodule 1 für die Spannungssignale, welche alle gleich aufgebaut sind, bestehen aus einem Spannungswandler 8, an den eine Anpassungsschaltung 9 angeschlossen ist und der ein Tiefpaßfilter 10 folgt. Die Eingangsmodule 2 für die Stromsignale sind ebenfalls alle gleich aufgebaut und bestehen aus einem Stromwandler 11, der sekundärseitig mit einer Strom-Spannungswandlerschaltung 12 verbunden ist, an die ein Tiefpaßfilter 13 angeschlossen ist. Zwei Eingangsmodule 1 für die Spannungssignale und zwei Eingangsmodule 2 für die Stromsignale sind am Ausgang mit je zwei Konstantstromquellen 3 verbunden. Die Konstantstromquellen 3 eines Eingangsmoduls 1, 2 sind an je einen Mikrocomputer 4, 5 angeschlossen.
Drei Eingangs module 1 für die Spannungssignale und drei Eingangsmodule 2 für die Stromsignale sind mit Leiterplattensteckern 14 verbunden. Die vier möglichen Steckverbindungen sind der Fig. 2 zu entnehmen. Wie hier ersichtlich ist, kann also ein Eingangsmodul 1, 2 an beide Mikrocomputer 4, 5 gelegt werden, oder der ein Eingangsmodul 1 an den einen und der andere Eingangsmodul 2 an den anderen Mikrocomputer 4, 5 oder umgekehrt angeschlossen werden.
Die Leiterplattenstecker 14 sind über Konstantstromquellen 3 mit den Mikrocomputern 4, 5 verbunden. Da die Schaltungsanordnung üblicherweise auf einer einzigen Leiterplatte angeordnet ist, wird zwecks Servicefreundlichkeit und aus Übersichtsgründen die Verbindung zwischen den Konstantstromquellen 3 und den Mikrocomputern 4, 5 mit Flachbandkabel 15 realisiert.

Entsprechend der Anforderung werden einige Eingangsmodule 1, 2 fix verdrahtet und bei den anderen kann die Verdrahtung über die Leiterplattenstecker 14 gewählt werden. Dadurch wird eine sehr große Flexibilität der Schaltung erreicht. Weiters wird auch die für einige Signale geforderte redundante Verarbeitung gewährleistet.

## Patentansprüche

1. Schaltungsanordnung zur Aufbereitung von analogen Strom- und Spannungssignalen für die Weiterverarbeitung in Mikrocomputern, **dadurch gekennzeichnet**, daß mindestens zwei Eingangsmodule (1) für die Aufbereitung von Spannungssignalen und mindestens zwei Eingangsmodule (2) für die Aufbereitung von Stromsignalen vorgesehen sind, von denen mindestens je ein Eingangsmodul (1, 2) über zwei Konstantstromquellen (3) mit zwei Mikrocomputern (4, 5) verbunden ist, und daß am Ausgang der anderen Eingangsmodule (1, 2) je zwei lösbare Verbindungen (6, 7) angeordnet sind, die Leiterplattenstecker (14), einpolige Leiterplattenschalter z.B. Dual-in-line Schalter oder einpolige elektronische Schalter sind, über die entweder mindestens ein Eingangsmodul (1; 2) unter Zwischenschaltung von zwei Konstantstromquellen (3) an beide Mikrocomputer (4, 5) anschließbar ist, oder mindestens je ein Eingangsmodul (1) für die Spannungssignale mit dem einen Mikrocomputer (4) und mindestens ein Eingangsmodul (2) für die Stromsignale mit dem anderen Mikrocomputer (5) über je eine Konstantstromquelle (3) verbindbar ist, und daß die Anzahl der Eingänge bei beiden Mikrocomputern (4, 5) gleich ist, jedoch immer kleiner als die Anzahl aller Eingangsmodule (1, 2), und daß die Anzahl der Konstantstromquellen (3) der Summe der Eingänge bei beiden Mikrocomputern (4, 5) entspricht, und daß die Eingangsmodule (1, 2), die lösbaren Verbindungen (6, 7) und die Konstantstromquellen (3) auf einer Leiterplatte angeordnet sind.

2. Schaltungsanordnung nach Anspruch 1, **dadurch gekennzeichnet**, daß die Eingangsmodule (1) für die Spannungssignale aus einem Spannungswandler (8), einer diesem nachgeschalteten Anpassungsschaltung (9) der ein Tiefpaßfilter (10) folgt, besteht, und daß die Eingangsmodule (2) für die Stromsignale aus einem Stromwandler (11), an den eine Strom-Spannungswandlerschaltung 12 mit Anpassung mit nachfolgendem Tiefpaßfilter (13) angeschlossen ist, aufgebaut sind.

3. Schaltungsanordnung nach Anspruch 1 oder 2, **dadurch gekennzeichnet**, daß an Stelle von jeweils vier lösbaren Verbindungen (6, 7), wobei zwei von einem Eingangsmodul (1) für die Spannungssignale und zwei von einem Eingangsmodul (2) für die Stromsignale sind, ein zweipoliger vierstufiger Schalter vorgesehen ist, bei dem jeder Wurzelanschluß mit einer Konstantstromquelle (3) verbunden ist, von denen jede mit einem Mikrocomputer (4, 5) verbunden ist, und daß in der ersten Schalterstellung der Eingangsmodul (1) für die Spannungssignale mit beiden Mikrocomputern (4, 5), in der zweiten Schalterstellung der Eingangsmodul (2) für die Stromsignale mit beiden Mikrocomputern (4, 5), in der dritten Schalterstellung der eine Eingangsmodul (1) mit dem einen Mikrocomputer (4) und der andere Eingangsmodul (2) mit dem anderen Mikrocomputer (5) und in der vierten Schalterstellung Eingangsmodule (1, 2) und Mikrocomputer (4, 5) in umgekehrter Reihenfolge miteinander verbunden ist bzw. sind.

4. Schaltungsanordnung nach einem der Ansprüche 1 bis 3, **dadurch gekennzeichnet**, daß die beiden Mikrocomputer (4, 5) über je ein Flachbandkabel (15) mit mehrpoligen Steckern mit den Konstantstromquellen (3) verbunden sind.

## Claims

1. A circuitry for preparing current and voltage analog signals, for retreating purposes in micro-computers, characterized in that at least two input modules (1) are provided for preparing voltage signals and at least two input modules (2) are provided for preparing current signals, with at least one input module (1, 2) being each time connected, through two direct current sources (3), to two micro-computers (4, 5), and in that, at the output of the other input module (1, 2), are respectively arranged two disconnectable links (6, 7) which are printed circuit board connections (14), printed circuit board unipolar switches, for example, dual-in-line switches, or unipolar electronic switches, through which either at least one input module (1, 2) can be connected, with two direct current sources (3) being interposed, to both micro-computers (4, 5), or at least one input module (1), for use with voltage signals, can be connected to one micro-computer (4) and at least an input module (2), for use with current signals, can be connected to the other micro-computer (5), each time through a direct current source (3), and in that the number of both micro-computer (4, 5) inputs is similar, although being always lower than the number of all the input modules (1, 2), and in that the number of direct current sources (3) corresponds to the sum of both micro-computer (4, 5) inputs, and in that input modules (1, 2), disconnectable links (6, 7) and direct current sources (3) are arranged on a printed circuit board.

2. The circuitry of claim 1, characterized in that said input modules (1) for use with voltage signals include a voltage converter (8), a matching circuit (9) which is disposed downstream thereof and followed by a lowpass filter (10), and in that said input modules (2) for use with current signals include a current converter (11), to which a current-voltage converter circuit is connected, the matching thereof being carried out with a subsequent lowpass filter (13).

3. The circuitry of claim 1 or 2, characterized in that, instead of four disconnectable links (6, 7) respectively, with two of them coming from an input module (1) for use with voltage signals and the other two from an input module (2) for use with current signals, a bilopar switch with four switching levels is provided, for which each base connection is connected to a direct current source (3), with each of them being connected to one micro-computer (4, 5), and in that, in the first switching position, the input module (1) for use with voltage signals is connected to both micro-computers (4, 5), in the second switching position, the input module (2) for use with current signals is connected to both micro-computers (4, 5), in the third switching position, a first input module (1) is connected to one micro-computer (4) and the other input module (2) is connected to the other micro-computer (5) and, in the fourth switching position, both input modules (1, 2) and micro-computers (4, 5) are connected together in the reversed order.

4. The circuitry of one of claims 1-3, characterized in that both micro-computers (4, 5) are connected to said direct current sources (3) each time through a flat ribbon cable (15), by means of multipolar spindle connectors.

## Revendications

1. Circuit pour la préparation de signaux analogiques d'intensité et de tension, pour le retraitement dans des micro-ordinateurs, caractérisé en ce qu'au moins deux modules d'entrée (1) sont prévus pour la préparation de signaux de tension et au moins deux modules d'entrée (2) sont prévus pour la préparation de signaux d'intensité, dont au moins chaque fois un module d'entrée (1, 2) est relié, par l'intermédiaire de deux sources de courant continu (3), à deux micro-ordinateurs (4, 5), et en ce que, à la sortie de l'autre module d'entrée (1, 2), sont respectivement disposées deux liaisons (6, 7) déconnectables, qui sont des prises pour plaquettes à circuit imprimé (14), des interrupteurs monopolaires de plaquettes à circuit imprimé, par exemple des interrupteurs dual-in-line, ou des interrupteurs électroniques monopolaires, par l'intermédiaire desquels soit au moins un module entrée (1; 2) peut être raccordé, avec interposition de deux sources de courant continu (3), aux deux micro-ordinateurs (4, 5), soit au moins un module d'entrée (1), destiné aux signaux de tension, peut être relié à un premier micro-ordinateur (4) et au moins un module d'entrée (2), destiné aux signaux d'intensité, peut être relié à l'autre micro-ordinateur (5), chaque fois par l'intermédiaire d'une source de courant continu (3), et en ce que le nombre des entrées des deux micro-ordinateurs (4, 5) est égal, cependant toujours inférieur au nombre de tous les modules d'entrée (1; 2), et en ce que le nombre des sources de courant continu (3) correspond à la somme des entrées des deux micro-ordinateurs (4, 5), et en ce que les modules d'entrée (1, 2), les liaisons (6, 7) déconnectables et les sources de courant continu (3) sont disposées sur une plaquette à circuit imprimé.

2. Circuit selon la revendication 1, caractérisé en ce que les modules d'entrée (1) destinés aux signaux de tension sont constitués d'un convertisseur de tension (8), d'un circuit d'adaptation (9) branché en aval de celui-ci et suivi par un filtre passe-bas (10), et en ce que les modules d'entrée (2) destinés aux signaux d'intensité sont constitués d'un convertisseur d'intensité (11), auquel est raccordé un circuit convertisseur intensité-tension, avec adaptation à l'aide d'un filtre passe-bas (13) subséquent.

3. Circuit selon la revendication 1 ou 2, caractérisé en ce que, au lieu respectivement de quatre liaisons (6, 7) déconnectables, deux venant d'un module d'entrée (1) pour les signaux de tension et deux venant d'un module d'entrée (2) pour les signaux d'intensité, il est prévu un interrupteur bipolaire à quatre niveaux de commutation, pour lequel chaque raccordement de racine est relié à une source de courant continu (3) dont chacune est reliée à un micro-ordinateur (4, 5), et en ce que, dans la première position d'interrupteur, le module d'entrée (1) destiné aux signaux de tension est relié aux deux micro-ordinateurs (4, 5), dans la deuxième position d'interrupteur, le module d'entrée (2) destiné aux signaux d'intensité est relié aux deux micro-ordinateurs (4, 5), dans la troisième position d'interrupteur, un premier module d'entrée (1) est relié à un micro-ordinateur (4) et l'autre module d'entrée (2) est relié à l'autre micro-ordinateur (5) et, dans la quatrième position d'interrupteur, les modules d'entrée (1, 2) et les micro-ordinateurs (4, 5) sont reliés ensemble dans l'ordre de succession inverse.

4. Circuit selon l'une des revendications 1 à 3, caractérisé en ce que les deux micro-ordinateurs (4, 5) sont reliés aux sources de courant continu (3) chaque fois par l'intermédiaire d'un câble ruban plat (15), à l'aide de prises à broches multipolaires.
